Europäisches Patentamt

European Patent Office

Office européen des brevets

(19)

(11)  EP 0 735 673 A1

(12)  EUROPÄISCHE PATENTANMELDUNG

(43) Veröffentlichungstag:
02.10.1996  Patentblatt 1996/40

(51) Int. Cl.⁶: **H03H 17/06**,  H03H 17/02

(21) Anmeldenummer: 96101638.3

(22) Anmeldetag: 06.02.1996

(84) Benannte Vertragsstaaten:
DE FR GB IT

(30) Priorität: 31.03.1995 DE 19511849

(71) Anmelder: **ANT Nachrichtentechnik GmbH**
**D-71522 Backnang (DE)**

(72) Erfinder: **Goeckler, Heinz, Dr.**
**D-71522 Backnang (DE)**

(54)  **Digitale Filtereinrichtung**

(57)  Bei einer digitalen Filtereinrichtung werden mehrere gleichartige FIR-Filterbausteine (UD1,...,UD3) verwendet. Diese Filterbausteine dienen zur Dezimation und Aufspaltung in Teilspektren ($\underline{H}_0$, $\underline{H}_1$).

Abgesehen vom Filtereingangsbaustein (UD1) werden nur jene Filterausgänge beschaltet, deren Signale nacheinander mit zueinander unterschiedlichen Filterfunktionen beaufschlagt wurden.

Diese Filtereinrichtung eignet sich insbesondere zum Demultiplexen von FDM-Signalen bzw. zum Multiplexen in transponierter Anordnung.

FIG.1

EP 0 735 673 A1

## Beschreibung

Die Erfindung geht aus von einem Filterbaustein gemäß dem Oberbegriff des Anspruchs 1.

## Stand der Technik

Aus International Journal of Satellite Communications, Vol.8, Seiten 79 bis 93, 1990, ist ein hierarchischer digitaler Mehrstufen-FDM-Demultiplexer nach dem HMM-Verfahren bekannt. In einer Eingangsstufe, bestehend aus einem linearphasigen digitalen Antialiasing FIR-Filter werden reellwertige Eingangssignale in komplexwertige Ausgangssignale in Verbindung mit einer Dezimation um den Faktor 2 umgewandelt. Außerdem wird in diesem Filterbaustein noch eine Frequenzverschiebung vorgenommen. An diesen Filterbaustein schließen sich andere Filterbausteine an, die ebenfalls eine Dezimation ausführen, ansonsten aber eine Frequenzweichenfunktion, d.h. eine Aufspaltung in jeweils unterschiedliche Teilspektren, vornehmen.

In einem Ausführungsbeispiel der EP 0 308 649 B1 ist zwar eine Filterbaumstruktur unter Verwendung gleichartiger Filterbausteine aufgezeigt, jedoch weisen diese Bausteine ausschließlich Weichenfunktionen auf.

## Vorteile der Erfindung

Die erfindungsgemäße Filtereinrichtung mit den kennzeichnenden Merkmalen des Anspruchs 1 eignet sich insbesondere zum Demultiplexen bzw. Multiplexen überabgetasteter Signale mit nur gleichartigen Filterbausteinen. Die Anzahl der Bausteine ist zwar größer als bei den eingangs genannten Filtereinrichtungen, aber es sind keine unterschiedlichen Bausteine auf Vorrat zu halten oder neu zu entwickeln. Auch ist weniger externer Verknüpfungdsaufwand pro Baustein nötig, was Verschaltungsfehlern entgegenwirkt. Bei nichtbeschalteten Ausgängen/Eingängen der Filterbausteine und den zugehörigen Filterkomponenten wird kaum Verlustleistung erzeugt. Durch die Regelmäßigkeit der Strukturen sind laufzeitbedingte Schaltzufälligkeiten (hazards) minimal, was die Zuverlässigkeit erhöht und den Einsatz in hoch zuverlässigen Satellitenanwendungen gestattet.

Zum Demultiplexen bzw. Multiplexen von FDM-Signalen ist die Einrichtung gemäß der Erfindung besonders flexibel einsetzbar. Es lassen sich reellwertige oder auch komplexwertige Eingangssignale ohne Änderung der Filterstrukturen oder Verschaltungen verarbeiten. Die Einrichtung gemäß der Erfindung ist beliebig erweiterbar.

## Zeichnungen

Ausführungsbeispiele der Erfindung sind in den Zeichnungen dargestellt. Es zeigen

Figur 1 ein Blockschaltbild der Filtereinrichtung,

Figur 2 Signalspektren mit den Filterübertragungsfunktionen,

Figur 3 eine Filterstruktur zur Zusammenfassung von Einzelspektren und

Figur 4 eine Blockstruktur der Filtereinrichtung mit einer Filterzelle.

## Beschreibung der Erfindung

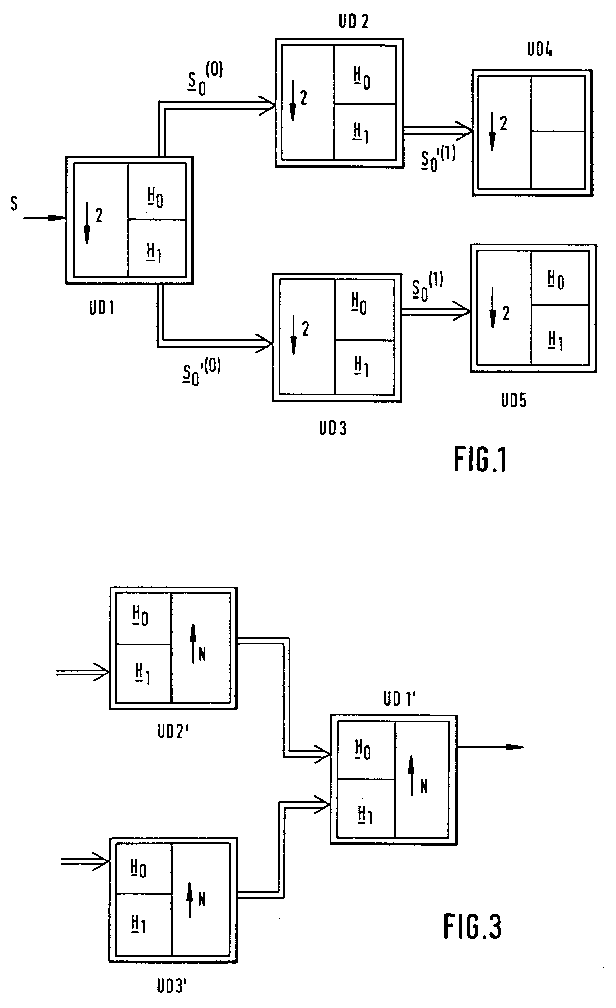

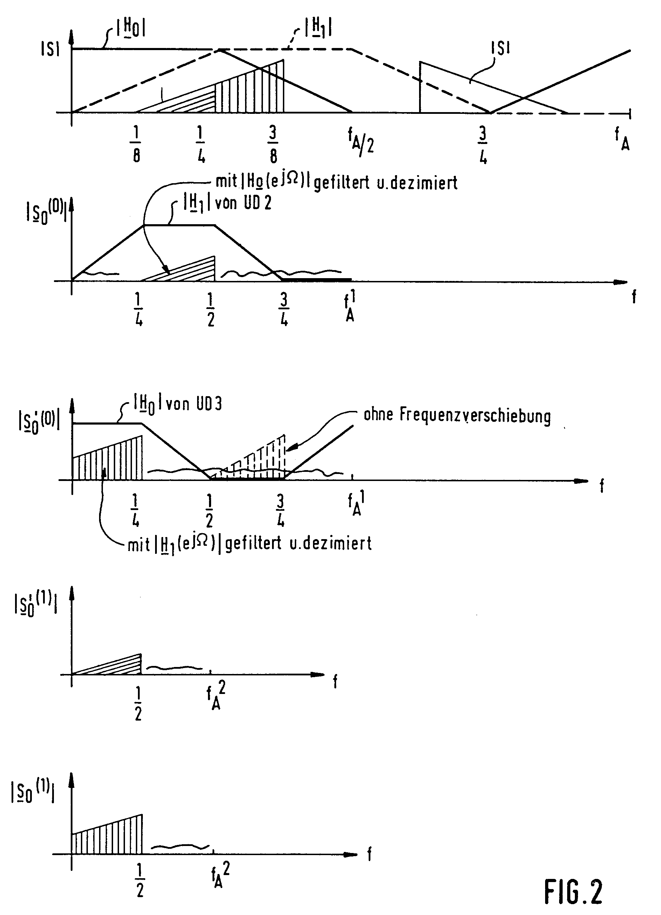

In Figur 1 sind mehrere gleichartige linearphasige FIR-Filterbausteine UD1, UD2, UD3, UD4 und UD5 dargestellt. Jeder dieser Filterbausteine UD1,...,UD5 besteht aus gleichartigen HMM-Zellen, die jeweils zur Dezimation eines Eingangssignals um einen ganzzahligen Faktor N, hier N = 2, geeignet sind und zur Aufspaltung des zugehörigen Eingangssignalspektrums in mindestens zwei Teilspektren, die durch die Filterübertragungsfunktionen $\underline{H}_0(e^{j\Omega})$ und $\underline{H}_1(e^{j\Omega})$ vorgegeben sind. Wie Figur 2 zeigt, wird ein mit der Abtastfrequenz $f_A = 2N \cdot L \cdot B$ um den Faktor N überabgetastetes Eingangssignal s, dessen Signalspektrum $|S|$ (Betrag der zeitdiskreten Fouriertransformierten) im Bereich $1/8 f_A$ bis $3/8 f_A$ liegt, mit den Filterübertragungsfunktionen $\underline{H}_0$ $(e^{j\Omega})$ und $\underline{H}_1$ $(e^{j\Omega})$ beaufschlagt. L bedeutet hier die Anzahl der gemultiplexten Kanalsignale und B die entsprechende Bandbreite dieser Signale. Der Betrag der Filterfunktion $|\underline{H}_0|$ (in Figur 2 durchgezogen) verläuft im Bereich 0 bis $1/4\ f_A$ (Durchlaßbereich) parallel zur Frequenzachse und klingt bis zum Wert $f_{A/2}$ auf Null ab. Der Betrag von $|\underline{H}_1|$ verläuft im Bereich von 1/4 bis 1/2 $f_A$ (Durchlaßbereich) parallel zur Frequenzachse und klingt außerhalb davon auf Null ab bei f = 0 bzw. 3/4 $f_A$. Die periodische Wiederholung von $|S|$ sowie der Filterfunktionen bleibt ohne Auswirkung.

In Figur 1 sind reellwertige Signale nicht unterstrichen und komplexwertige Signale durch Unterstrich gekennzeichnet, das überabgetastete Eingangssignal s ist im gezeigten Ausführungsbeispiel demnach reellwertig. Wie Figur 1 zeigt, wird das mit der komplexen Filterfunktion $\underline{H}_0(e^{j\Omega})$ beaufschlagte um den Faktor N = 2 dezimierte komplexwertige Signal als Eingangssignal $\underline{s}_0{}^{(0)}$ für den Filterbaustein UD2 verwendet. Das mit der Filterfunktion $\underline{H}_1$ $(e^{j\Omega})$ mit komplexen Koeffizienten beaufschlagte dezimierte Signal als Eingangssignal $\underline{s}_0'{}^{(0)}$ für den Filterbaustein UD3. Es werden erfindungsgemäß nur jene Ausgänge der Filterbausteine UD2 und UD3 als Endausgänge der Filtereinrichtung oder als Anschlußpunkte für zusätzliche nachfolgende Filterbausteine UD4, UD5 verwendet, die zu folgenden verketteten Übertragungsfunktionen führen:

$$\underline{H}_A = \underline{H}_0(e^{j\Omega}) \cdot \underline{H}_1(e^{jN\Omega}) \text{ und}$$

$$\underline{H}_B = \underline{H}_1(e^{j\Omega}) \cdot \underline{H}_0(e^{jN\Omega}),$$

wobei $\Omega = 2\pi f/f_A$ ist. Die entsprechenden Ausgangssignale von UD2 und UD3 sind mit $\underline{s}_0'{}^{(1)}$ und $\underline{s}_0{}^{(1)}$ bezeichnet.

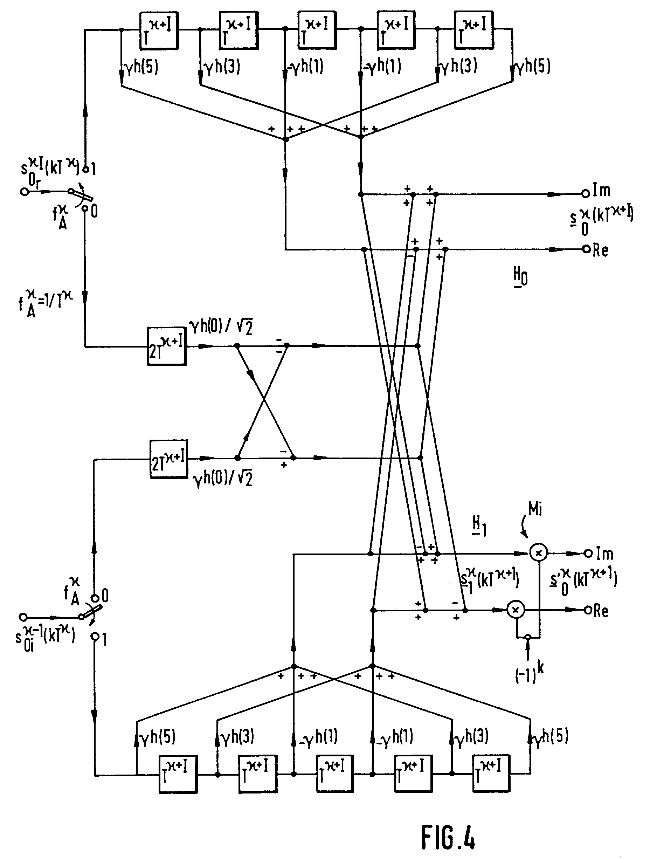

In Figur 2, Zeile 2, ist der Betrag des Signalspektrums $\underline{s}_0^{(0)}$ dargestellt, also das mit der Filterfunktion $|\underline{H}_0(e^{j\Omega})|$ beaufschlagte Spektrum. Nur im Bereich 1/4 bis 1/2 $f_A^1$ erscheint ein Nutzsignalanteil. $f_A^1$ ist hier die mit den Faktor N dezimierte Eingangsabtastfrequenz $f_A$, hier also $f_A^1 = f_{A/2}$. Der Betrag des Signalspektrums $|\underline{S}_0'^{(0)}|$, also das mit der Übertragungsfunktion $|\underline{H}_1(e^{j\Omega})|$ beaufschlagte Spektrum ist in der dritten Zeile von Figur 2 dargestellt, allerdings um den Betrag $1/2f_A^1$ in der Frequenz nach links verschoben. Ohne die Frequenzverschiebung ist seine Lage durch den gestrichelt umrahmten Bereich gekennzeichnet. Diese Frequenzverschiebung wird durch eine Mischung erreicht, die in Zusammenhang mit Figur 4 noch beschrieben wird. Die beiden letzten Zeilen von Figur 2 zeigen die Signalausgangsspektren $|\underline{S}_0'^{(1)}|$ und $\underline{S}_0^{(1)}|$; d.h. jene Spektren, die an den Endausgängen der Filtereinrichtung erscheinen oder zur Weiterverarbeitung, hier in den Filterbausteinen UD4 und UD5, vorgesehen sind. Für die Abtastfrequenz $f_A^2$ gilt: $f_A^2 = (1/2)f_A^1 = (1/4)f_A$.

Anstelle des Dezimationsfaktors N = 2 können natürlich auch andere, insbesondere Vielfache von 2, gewählt werden. Die für einen FDM-Demultiplexer vorgestellte Filtereinrichtung zur Zerlegung von beispielsweise L-Kanalsignalen mit jeweils einer Bandbreite B läßt sich natürlich auch als Multiplexer zur entsprechenden Aufbereitung (Zusammenfassung) von Kanalsignal-Einzelspektren oder -Kanalbündeln modifizieren. In Figur 3 ist ein entsprechendes Blockschaltbild (transponierte Struktur) aufgezeigt. Der Faktor N gibt dann den Faktor für die Aufwärts-Abtastratenwandlung an. Die Filtereingangsbausteine sind dann mit UD2' und UD3' bezeichnet und der Filterausgangsbaustein mit UD1'. Nur jenen Eingängen der Filterbausteine UD2' und UD3' werden Eingangssignale zugeführt, die zu folgenden verketteten Filterübertragungsfunktionen führen (Bezugsabtastfrequenz ist wiederum die höchste Abtastfrequenz $f_A$ - hier am Ausgang):

$$\underline{H}'_A(e^{j\Omega}) = \underline{H}_1(e^{jN\Omega}) \cdot \underline{H}_0'(e^{j\Omega})$$

$$\underline{H}'_B(e^{j\Omega}) = \underline{H}_0(e^{jN\Omega}) \cdot \underline{H}_1'(e^{j\Omega})$$

Figur 4 zeigt eine Blockstruktur einer Filterzelle, also die Realisierung eines Filterbausteins. Es kann aus der Filterstruktur gemäß Figur 4 der EP 08 649 B1 abgeleitet werden: $\kappa$ ist hier der Index der Dezimationsstufen, $\gamma$ gibt den Skalierungsindex an. Im Gegensatz zum in Figur 1 dargestellten Beispiel ist das Eingangssignal hier komplexwertig ($s_{0r}$ und $s_{0i}$). Zur zuvor behandelten Frequenzverschiebung des mit der Übertragungsfunktion $[\underline{H}_1]$ beaufschlagten Spektrums dient die Mischeinrichtung Mi (Multiplikation des Imaginär- und Realteils mit $(-1)^k$; Zeitfaktor k = ...-1, 0, +1...).

## Patentansprüche

1. Digitale Filtereinrichtung bestehend aus mehreren gleichartigen linearphasigen FIR-Filterbausteinen (UD1,..,UD3) mit komplexen Koeffizienten, die jeweils zur Dezimation eines Eingangssignals um einen ganzzahligen Faktor N und zur Aufspaltung des zugehörigen Eingangssignalspektrums in mindestens zwei durch die Filterübertragungsfunktionen $\underline{H}_0(e^{j\Omega})$ und $\underline{H}_1(e^{j\Omega})$, sowie ggf. weiterer Filterübertragungsfunktionen, vorgegebene Teilspektren mit entsprechend dem Dezimationsfaktor N verminderter Nutzbandbreite geeignet sind, wobei die Ausgänge jedes Filterbausteins (UD1,...,UD3) jeweils die mit den Filterübertragungsfunktionen $\underline{H}_0(e^{j\Omega})$ und $\underline{H}_1(e^{j\Omega})$ ausgefilterten Teilspektren führen, dadurch gekennzeichnet, daß nur jene Ausgänge der weiteren Filterbausteine (UD2, UD3,...) als Endausgänge der Filtereinrichtung oder als Anschlußpunkte für zusätzliche nachfolgende Filterbausteine (UD4, UD5) vorgesehen sind, die zu folgenden verketteten Filterübertragungsfunktionen führen:

$$\underline{H}_A = \underline{H}_0(e^{j\Omega}) \cdot \underline{H}_1(e^{jN\Omega}) \text{ und}$$

$$\underline{H}_B = \underline{H}_1(e^{j\Omega}) \cdot \underline{H}_0(e^{jN\Omega}),$$

sowie im Falle von mehr als zwei Aufspaltungen entsprechenden weiteren Verkettungen, mit $\Omega = 2\pi f/f_A$, $f_A$ = Abtastfrequenz des Eingangssignals.

2. Filtereinrichtung nach Anspruch 1, dadurch gekennzeichnet, daß das Eingangssignalspektrum um mindestens den Faktor 2 überabgetastet ist.

3. Filtereinrichtung nach Anspruch 1 oder 2, dadurch gekennzeichnet, daß das Eingangssignal ein reellwertiges oder komplexwertiges Signal ist.

4. Filtereinrichtung nach einem der Ansprüche 1 bis 3, dadurch gekennzeichnet, daß für ein Eingangssignalspektrum im Bereich von $(1/8)f_A$ bis $(3/8)f_A$ die Filterübertragungsfunktion $\underline{H}_0(e^{j\Omega})$ ihre obere Eckfrequenz bei $(1/4)f_A$ und die Filterfunktion $\underline{H}_1(e^{j\Omega})$ ihre untere Eckfrequenz bei $(1/4)f_A$ und ihre obere Eckfrequenz bei $(1/2)f_A$ aufweist.

5. Filtereinrichtung nach Anspruch 4, dadurch gekennzeichnet, daß jeweils jener Ausgang eines Filterbausteins (UD1,...,UD3), der die Filterübertragungsfunktion $\underline{H}_1(e^{j\Omega})$ bzw. $\underline{H}_1(e^{jN\Omega})$ führt, einen Mischer (Mi) zur Frequenzverschiebung seines Signalspektrums aufweist.

6. Digitale Filtereinrichtung nach einem der Ansprüche 1 bis 5, dadurch gekennzeichnet, daß die Filterbausteine in einer transponierten Struktur zu einer der Aufspaltung in Teilspektren entsprechenden Zusammenfassung von Einzelspektren und anstelle einer Dezimation zu einer Aufwärtsabtastraten-Wandlung mit einer um den Faktor N erhöhten Nutzbandbreite geeignet sind und daß nur jene Eingänge der eingangsseitigen Filterbausteine (UD3',...,UD2') für die Zuleitung von Einzelspektren $\underline{H}_0(e^{jN\,\Omega})$ bzw. $\underline{H}_1(e^{jN\Omega})$ vorgesehen sind, die mit dem/den sich anschließenden weiteren Filterbaustein/en (UD1') zu folgenden verketteten Filterübertragungsfunktionen führen:

$$\underline{H}'_A(e^{j\Omega}) = \underline{H}_1(e^{jN\Omega}) \cdot \underline{H}_0'(e^{j\Omega})$$

$$\underline{H}'_B(e^{j\Omega}) = \underline{H}_0(e^{jN\Omega}) \cdot \underline{H}_1'(e^{j\Omega})$$

7. Verwendung der digitalen Filtereinrichtung nach einem der Ansprüche 1 bis 6, zum Demulitplexen bzw. Multiplexen von FDM-(Frequency Division Multiplex)Signalen.

UD 2

UD4

$\underline{S}_0{}^{(0)}$

$\downarrow 2$    $\underline{H}_0$

$\underline{H}_1$

$\downarrow 2$

$S$

$\downarrow 2$    $\underline{H}_0$

$\underline{H}_1$

UD1

$\underline{S}_0{}^{'(1)}$

$\underline{S}_0{}^{'(0)}$

$\downarrow 2$    $\underline{H}_0$

$\underline{H}_1$

$\underline{S}_0{}^{(1)}$

$\downarrow 2$    $\underline{H}_0$

$\underline{H}_1$

UD5

UD3

## FIG.1

$\underline{H}_0$

$\underline{H}_1$    $\uparrow N$

UD2'

UD 1'

$\underline{H}_0$

$\underline{H}_1$    $\uparrow N$

$\underline{H}_0$

$\underline{H}_1$    $\uparrow N$

UD3'

## FIG.3

FIG.2

FIG.4

Europäisches
Patentamt

**EUROPÄISCHER RECHERCHENBERICHT**

Nummer der Anmeldung

EP 96 10 1638

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| D,A | EP-A-0 308 649 (ANT NACHRICHTENTECH) 29.März 1989 * Seite 1, Zeile 27 - Seite 3, Zeile 32; Abbildungen * --- | 1 | H03H17/06 H03H17/02 |
| D,A | INTERNATIONAL JOURNAL OF SATELLITE COMMUNICATIONS, Bd. 8, 1.Januar 1990, Seiten 79-93, XP000563988 EYSSELE H ET AL: "SIMULATION OF AN ON-BOARD HIERARCHICAL MULTISTAGE DIGITAL FDM DEMULTIPLEXER FOR MOBILE SCPC SATELLITE COMMUNICATIONS" * Absatz 2; Abbildungen * ----- | 1 | |
| | | | RECHERCHIERTE SACHGEBIETE (Int.Cl.6) |
| | | | H03H |

Der vorliegende Recherchenbericht wurde für alle Patentansprüche erstellt

| Recherchenort | Abschlußdatum der Recherche | Prüfer |
|---|---|---|
| DEN HAAG | 9.August 1996 | D/L PINTA BALLE.., L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
............................................................................
& : Mitglied der gleichen Patentfamilie, übereinstimmendes Dokument

EPO FORM 1503 03.82 (P04C03)

8